# EUROPEAN PATENT SPECIFICATION

(11) **EP 0 465 026 B1**
(45) Date of publication and mention of the grant of the patent: **30.10.1996**
(21) Application number: 91305325.2
(22) Date of filing: 12.06.1991
(51) Int. Cl.: H01L 31/0224, H01L 31/0376, H01L 31/075

(54) **Method of manufactoring a photoelectric device made of hydrogenated amorphous silicon**
Herstellungsverfahren einer fotoelektrischen Vorrichtung aus hydriertem amorphem Silizium
Méthode de fabrication d'un dispositif photo-électrique en silicium amorphe hydrogéné

(30) Priority: 02.07.1990 JP 174743/90; 02.07.1990 JP 174751/90
(43) Date of publication of application: 08.01.1992
(73) Proprietor: MATSUSHITA ELECTRIC INDUSTRIAL CO., LTD., Kadoma-shi, Osaka-fu, 571 (JP)
(72) Inventor: Kanbara, Teruhisa, Ikeda-shi, Osaka 563 (JP); Kondo, Shigeo, Hirakata-shi, Osaka 573 (JP)
(74) Representative: Crawford, Andrew Birkby

(56) References cited:
- US-A- 4 117 506
- US-A- 4 200 473
- JOURNAL OF THE ELECTROCHEMICAL SOCIETY. vol. 135, no. 2, February 1988, MANCHESTER, NEW HAMPSHIRE US pages 431 - 436; S.ARIMOTO ET AL.: 'ANODIC OXYDATION FOR ENHANCEMENT OF FABRICATION YIELD AND EFFICIENCY OF AMORPHOUS SILICON SOLAR CELLS'
- APPLIED PHYSICS LETTERS. vol. 37, no. 9, 1 November 1980, NEW YORK US pages 826 - 828; A.MADAN ET AL.: 'METAL-INSULATOR-SEMICONDUCTOR SOLAR CELLS USING AMORPHOUS Si:F:H ALLOYS'
- JAPANESE JOURNAL OF APPLIED PHYSICS. vol. 29, no. 11, November 1990, TOKYO JP pages 2080 - 2081; M.FARAJI ET AL.: 'PHOTOVOLTAIC, I-V AND C-V CHARACTERISTICS OF SnO2/SiO2/a-Si:H/mc-Si:H STRUCTURES'

## Description

### BACKGROUND OF THE INVENTION

### INDUSTRIAL APPLICATION

This invention is related to the manufacture of photo-electric devices made of hydrogenated amorphous silicon, such as solar-cells and photo-sensors to convert near-ultraviolet, visible, or near-infrared light energies into electrical energy or changes in electrical resistance respectively.

### PRIOR ART

Various constructions of solar-cells or photo-sensors made of hydrogenated amorphous silicon have been proposed. For an example, an amorphous silicon solar-cell comprised of a transparent substrate, transparent electrode, P-I-N type hydrogenated amorphous silicon layer, and an aluminum collector electrode layer which are sequentially overlaid is known. An amorphous silicon photo-sensor comprised of a transparent substrate, transparent electrode, N-I-N type hydrogenated amorphous silicon layer and collector electrode which are sequentially overlaid is also known. This cell perceives light by detecting changes in electrical resistance between the transparent electrode and the collector electrode.

In such construction, a metal oxide such as tin-oxide (SnO₂) or indium oxide (In₂O₃) is employed to construct the transparent electrode layer which sandwiches an I-type amorphous silicon layer against the collector electrode layer. A change in electrical current caused by light irradiation introduced on the transparent electrode under the application of constant voltage (between the transparent electrode and collector electrode) is utilized for sensing the incident light.

However, it is generally difficult to establish and maintain adequately low electrical resistance between the transparent electrode layer and the collector electrode layer, and the I-type amorphous silicon layer (see e.g. Sensor Utilization Technology, published by the Association of Industrial Investigation of Japan).

Therefore, photo-sensor devices have generally been provided with either an N- or P-type hydrogenated amorphous silicon surface layer doped with either phosphorous or boron on a hydrogenated amorphous silicon layer provided between the transparent electrode and the collector electrode for increasing the carrier densities therein in order to establish substantially low electrical resistances between the transparent and collector electrode layers and the I-type amorphous silicon layer.

However, a substantial degradation is obvious with solar-cells and photo-sensors having the above-described conventional construction when these are placed in a high-temperature environment on the order of 120°C. This phenomenon is attributed to a so-called metal migration caused by thermal diffusion of metal atoms from the electrodes into the amorphous silicon layer.

As an effective measure to prevent such metal migration taking place in in elevated temperature environment, a method providing a chemically inactive electrical insulator between the amorphous silicon layer and the metal electrode layer was introduced.

For example, an electric device constructed of; a glass substrate/ ITO transparent electrode/ N-type hydrogenated amorphous silicon layer/ I-type hydrogenated amorphous silicon layer/ (an insulator layer)/ (a collector electrode made of metal elements), has been proposed. A metal oxide such as TiO₂, ZrO₂, SiO₂, Nb₂O₃, RuO₂ was proposed to construct the insulator layer, and a higher work-function metal such as Pt, Au, or Pd was recommended to construct the collector electrode.

With an electrical device of such construction where a TiO₂ layer is employed as a chemically inactive electrical insulator for preventing thermal diffusion of platinum (which constitutes the collector electrode) into the amorphous silicon layer, the thickness of the TiO₂ layer must be so thin that the quantum tunneling of electrons is permissible at the boundary in order to assure an adequate electrical contact between the collector electrode layer and the amorphous silicon layer, but if the TiO₂ layer is too thin, it may not be able to prevent the thermal diffusion of platinum atoms from the electrode layer into the amorphous silicon layer.

Thus competing interests affect the construction of electric devices having an above-described construction: adequate electrical contacts between collector electrode layer and amorphous silicon layer; and the high-temperature stability of the device. Since the material constituting the collector electrode has to be a noble metal such as Pt, Au, or Pd, and the use of low-cost material such as aluminum is prohibited in this case, a higher production cost of such device is inevitable.

US-A-4117506 discloses a semiconductor device which has an electrically insulating layer of oxide betwen a body of amorphous silicon and a metallic film. The insulating layer formed by heating the body in air or oxygen at 200° - 300°C is sufficiently thin that charge carriers are capable of tunneling through the insulating layer while the insulating layer increases the open circuit voltage of the overall device without adversely effecting the short circuit current density.

US-A-4200473 similarly discloses a thin insulating layer and additionally a thin doped layer adjacent to the junction forming metal layer again to exhibit increase opened circuit voltages.

The present invention provides a method of manufacturing a photo-electric device including a hydrogenated amorphous silicon layer, comprising the steps of:

washing the surface of said hydrogenated amorphous silicon surface in water and forming a chemically inactive layer thereon by drying said hydrogenated amorphous silicon surface under infrared irradiation in an oxygen containing atmosphere; and
forming an electrode layer on said chemically inactive layer.

By way of this invention an improved electrical contact is established between the hydrogenated amorphous silicon and the metal electrode through such a chemically inactive layer which prevents a direct contact of the hydrogenated amorphous silicon and the metal electrode.

In this case, adequate electrical contact can be established between the amorphous silicon and the electrode which may be made of a low cost metal such as aluminum. Furthermore, this electric device is stable at high-temperatures.

### BRIEF DESCRIPTION OF THE DRAWINGS

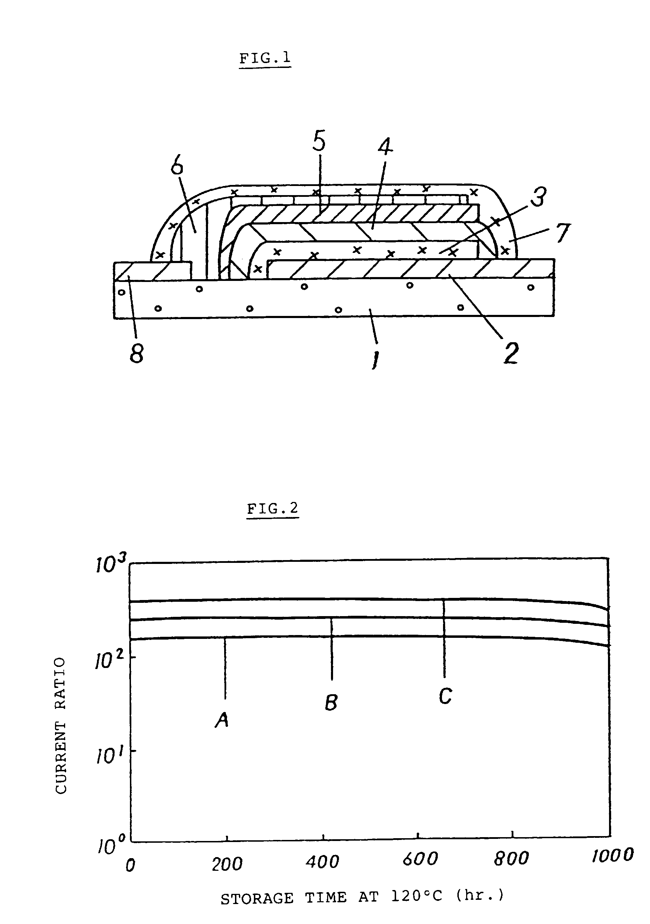

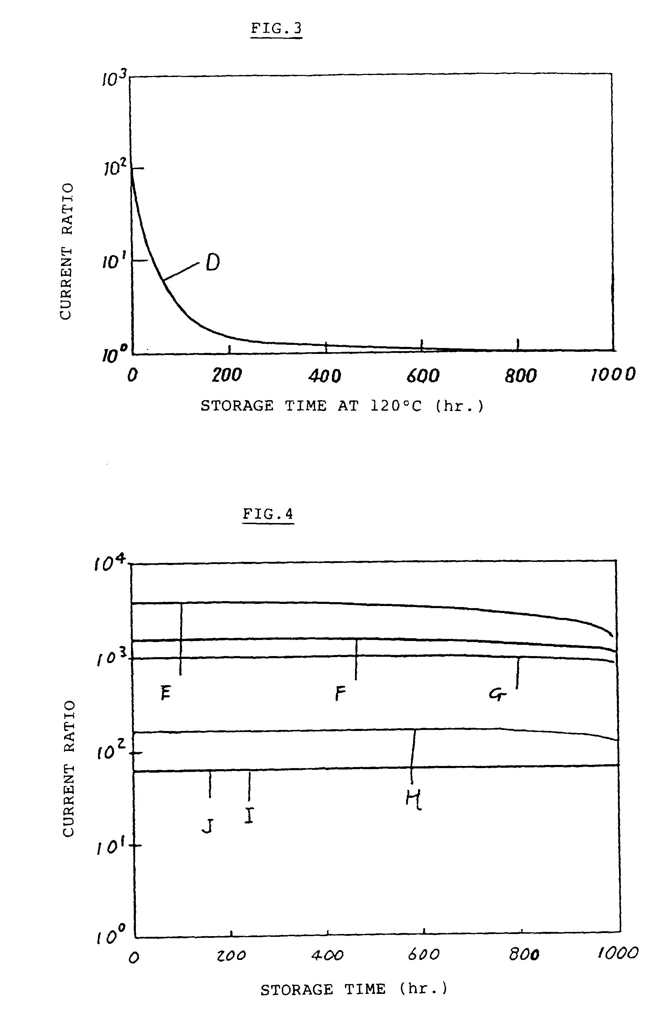

Fig. 1 shows a schematic cross-section of electric device A manufactured according to the present invention. Fig. 2 shows a high-temperature storage characteristics of the electric devices A, B, and C, while Fig. 3 shows, high-temperature storage characteristics of a comparative electric device D. Fig. 4 shows high-temperature storage characteristics of the electric devices E, F, G, H, I, and J having different collector electrode materials.

### EMBODIMENTS OF THE INVENTION

Two embodiments of the invention are now illustrated in the following by referring the attached drawings.

### Embodiment-1

### Electric Device A

Fig. 1 shows a photo-detector device wherein the electrical connection is established between a hydrogenated amorphous silicon layer and a collector electrode comprised mainly of metal elements, by using an oxide layer of the hydrogenated amorphous silicon layer. Fig. 1 shows such a photo-detector device fabricated on a 1.1 mm thick and 15x15 mm square glass substrate 1 on which a 10x10 mm ITO layer made of indium oxide and tin oxide is deposited at a thickness of 0.1 micrometer as a transparent electrode 2.

An 11x11 mm square N-type amorphous silicon layer 3 is deposited on the transparent electrode 2 at a thickness of 400Å by a plasma CVD (Chemical Vapor Deposition) method (10Å = 1nm). The deposition is conducted at a deposition rate of 2Å/sec in a mixed-gas atmosphere of SiH₄ + P₂H₆ (P₂H₆/SiH₄ = 0.003) at a pressure of 0.5 Torr, and a temperature of 220°C.

The I-type amorphous silicon layer 4 is continuously deposited at a thickness of 4000Å by a plasma CVD method. The deposition is conducted at a deposition rate of 2Å/sec in an atmosphere of SiH₄ gas at a pressure of 66.6 Pa (0.5 Torr) and a temperature of 220°C.

Then, the surface of the I-type amorphous silicon layer 4 is washed in water, and is dried in air by applying infrared irradiation to form a chemically inactive layer 5 of the I-type amorphous silicon layer 4.

After this, a 9x9 mm square aluminum collector electrode 6 is vacuum vapor deposited on chemically inactive layer 5 at a thickness of 2000Å. The deposition is conducted at a deposition rate of 20Å/sec in a vacuum atmosphere of 0.004 Pa (3 x 10⁻⁵ Torr). The entire device construction is then sealed by a sealing layer 7 made of epoxy resin for completing the fabrication process of the photo-detector.

The lead terminal 8 for the ITO transparent electrode is fabricated at the time of the ITO transparent electrode fabrication. The thickness of chemically inactive layer 5 is determined, after the deposition of said aluminum collector electrode 6, by using a secondary-ion mass spectrometer, and it is found to be approximately 100Å. Moreover, it is found that oxygen is homogeneously distributed in aluminum collector electrode 6 at a content of 20 atom%.

Therefore, the construction of the photo-detector takes a final form of: a glass substrate/ ITO / N-type hydrogenated amorphous silicon layer/ I-type hydrogenated amorphous silicon layer/ chemically inactive layer mainly of I-type hydrogenated amorphous silicon layer/ an (aluminum + oxygen) layer.

### Electric Device B

Another possible electric device, or electric device B, has a different construction comprised of: a glass substrate/ ITO / N-type hydrogenated amorphous silicon layer/ I-type hydrogenated amorphous silicon layer/ N-type hydrogenated amorphous silicon layer/ chemically inactive layer mainly of N-type hydrogenated amorphous silicon layer/ (aluminum + oxygen) layer.

### Electric Device C

The electric device C has a still different device construction; i.e.: a glass substrate / ITO / N-type hydrogenated amorphous silicon layer/ I-type hydrogenated amorphous silicon layer / P-type hydrogenated amorphous silicon layer / chemically inactive layer mainly of P-type hydrogenated amorphous silicon layer / (aluminum + oxygen) layer.

In fabricating electric device C, the P-type amorphous silicon layer is plasma CVD deposited at a thickness of 400Å. The deposition is conducted at a deposition rate of 2Å/sec in a mixed gas atmosphere of SiH₄ + B₂H₅ (B₂H₅/SiH₄ = 0.003) at a pressure of 0.5 Torr, and a temperature of 220°C.

### Comparative example

### Electric Device D.

For the purpose of comparative evaluation of these devices, a photo-sensor having a conventional construction is fabricated. The device construction in this case is: a glass substrate / ITO / N-type hydrogenated amorphous silicon layer / I-type hydrogenated amorphous silicon / N-type hydrogenated amorphous silicon layer / an aluminum layer, and this is named electric device D.

A process virtually identical with those employed for the electric device A is employed for the electric device D. That is, an aluminum electrode is directly deposited on an N-type hydrogenated amorphous silicon layer deposited previously on an I-type hydrogenated amorphous silicon layer. The deposition of the aluminum electrode is made at rate of 20Å/sec by a vacuum deposition method conducted in an argon atmosphere at 133 10⁻⁶ Pa (1 x 10⁻⁶ Torr).

The method of construction of the aforementioned N-type hydrogenated amorphous silicon layer is the same as that of the electric device A, and other constituting elements are also identical with those for the electric device A.

The degradation of electric devices A, B, C and D during a high-temperature storage period is examined, and the results are shown in Figs. 2 and 3.

Individual characteristics of these device are determined by measuring their respective current flows (the current when light irradiation in ON / the current when light irradiation is OFF) between the transparent electrode (positive polarity) and the collector electrode (positive) when a constant voltage of 1 volt is applied to the devices at 120°C, and the light irradiation incident on the device is turned ON and OFF.

A 550nm monochromatic light source capable of delivering an irradiation intensity of 100 micro W/cm² is used in these experiments. Figs. 2 and 3 show the current ratio or the gain of photo-sensor plotted on the vertical axis and the time exposed to the 120°C atmosphere plotted along the horizontal axis.

As these results indicate, the electric devices A, B, and C, after undergoing a 120°C storage test for 1000 hours, showed virtually no changes in the respective current ratios. However, the degradation of the comparative electric device D from the initial stage is so significant (as shown in Fig. 3) that it became inoperational as a photo-sensing device within a short time period.

The same principles apply to electric devices having NI-type, NIN-type, or NIP-type constructions. The experiments obtained with devices having PI-type and PIN type structures also showed the same results. Furthermore, an experiment is conducted where the same device is constructed on an aluminum substrate, reversing the order of layer construction, and the same result is obtained.

### Embodiment-2

Whereas, the electric device A shown in Embodiment-1 employs an aluminum collector electrode, electric devices using metals and alloys other than aluminum are experimentally fabricated, and these devices are designated E, F, G, H, I, and J. The materials employed for the collector electrode and the types and contents (atomic%) of non-metal elements contained therein are listed in Table 1.

The device construction and fabrication method for these devices are identical with those used for the electric device A in Embodiment-1 except for the collector electrode material. The collector electrode is deposited by means of an electron-beam deposition method.

**Table I**

| Device | Electrode Material | Non-metal Material | Non-metal Content (atomic%) |
|---|---|---|---|
| E | Al + Mg (95 : 5 atomic ratio) | Oxygen | 30 |
| F | Al + Ti (4 : 6 atomic ratio) | Oxygen | 5 |
| G | Al + Si (9 : 1 atomic ratio) | Oxygen | 10 |
| H | Ni | Oxygen | 5 |
| I | Ti | Nitrogen | 2 |
| J | Ti + Ni (1 : 1 atomic ratio) | Nitrogen | 1 |

The light-sensitivities of these devices are measured by a method identical with that for the devices fabricated in Embodiment-1, and the results are reported in Fig. 4.

The results in Fig. 4 show improvement of the high-temperature storage characteristics of these devices over those of electric devices having conventional constructions.

In addition to the results obtained with various collector electrode materials shown in Table 1, various stainless steels, aluminum alloys, and nitrided steels are also tested. As a result of these experiments, it was confirmed that any single metal material or alloy of metals selected from the metal group of Li, Na, Mg, Al, Si, K, Ca, Ti, V, Cr, Mn, Fe, Ce, Ni, Cu, Zn, Ga, Ge, Zr, Nb, Mo, Pd, Ag, Cd, In, Sn, Ba, Ta, W, Pt, Au, and Pb can be used as a collector electrode material.

Furthermore, it is also confirmed that an addition of at least one non-metal element selected from the group including carbon, nitrogen, and oxygen in more than 1 atomic% is effective to improve the thermal stability of these electric devices. This effect can be attributed to the higher energy required to produce metal-migrations.

Confirmed also is a definite effectiveness of stainless steel, or such material having better anti-corrosion properties, when these are employed to construct the collector electrode. It improves not only the high-temperature storage characteristics but the anti-humidity characteristics.

## Claims

1. A method of manufacturing a photo-electric device including a hydrogenated amorphous silicon layer, comprising the steps of:
washing the surface of said hydrogenated amorphous silicon surface in water and forming a chemically inactive layer thereon by drying said hydrogenated amorphous silicon surface under infrared irradiation in an oxygen containing atmosphere; and
forming an electrode layer on said chemically inactive layer.

2. A method according to claim 1 in which said electrode layer formed on said chemically inactive layer is a collector electrode.

3. A method according to claim 1 in which said electrode layer formed on said chemically inactive layer is a transparent electrode.

4. A method according to any of claims 1 to 3 comprising:
forming a hydrogenated amorphous silicon layer of either P-type or N-type on substrate, and
forming an I-type hydrogenated amorphous silicon layer free of impurities on said N-type or P-type hydrogenated amorphous silicon layer;
and in which the surface of said I-type hydrogenated amorphous silicon is washed in said washing step.

5. A method according to any one of claims 1 to 3 comprising:
forming a hydrogenated amorphous silicon layer of either P-type or N-type on substrate,
forming an I-type hydrogenated amorphous silicon layer free of impurities on said N-type or P-type hydrogenated amorphous silicon layer, and
forming a hydrogenated amorphous silicon layer of either P-type or N-type on said I-type hydrogenated amorphous silicon layer,
and in which the surface of the second mentioned P-type or N-type hydrogenated amorphous silicon is washed in said washing step.

## Patentansprüche

1. Verfahren zum Herstellen einer photoelektrischen Vorrichtung, die eine hydrierte amorphe Siliziumschicht einschließt, das die Schritte umfaßt:
Waschen der Oberfläche der hydrierten amorphen Siliziumoberfläche in Wasser und Bilden einer chemisch inaktiven Schicht darauf durch Trocknen der hydrierten amorphen Siliziumoberfläche unter Infrarotbestrahlung in einer sauerstoffhaltigen Atmosphäre und
Bilden einer Elektrodenschicht auf der chemisch inaktiven Schicht.

2. Verfahren nach Anspruch 1, bei dem die auf der chemisch inaktiven Schicht gebildete Elektrodenschicht eine Kollektorelektrode ist.

3. Verfahren nach Anspruch 1, bei dem die auf der chemisch inaktiven Schicht gebildete Elektrodenschicht eine transparente Elektrode ist.

4. Verfahren nach einem der Ansprüche 1 bis 3, das umfaßt:
Bilden einer hydrierten amorphen Siliziumschicht entweder des P-Typs oder des N-Typs auf Substrat und
Bilden einer I-Typ hydrierten amorphen Siliziumschicht frei von Fremdstoffen auf der N-Typ oder P-Typ hydrierten amorphen Siliziumschicht,
und bei dem die Oberfläche des I-Typ hydrierten amorphen Siliziums in einem Waschschritt gewaschen wird.

5. Verfahren nach einem der Ansprüche 1 bis 3, das umfaßt:
Bilden einer hydrierten amorphen Siliziumschicht entweder des P-Typs oder des N-Typs auf Substrat;
Bilden einer I-Typ hydrierten amorphen Siliziumschicht frei von Fremdstoffen auf der N-Typ oder P-Typ hydrierten amorphen Siliziumschicht und
Bilden einer hydrierten amorphen Siliziumschicht entweder des P-Typs oder des N-Typs auf der I-Typ hydrierten amorphen Siliziumschicht,
und bei dem die Oberfläche des zweiten erwähnten P-Typ oder N-Typ hydrierten amorphen Siliziums in einem Waschschritt gewaschen wird.

## Revendications

1. Procédé de fabrication d'un dispositif photoélectrique incluant une couche en silicium amorphe hydrogéné, comprenant les étapes de :
lavage de la surface de ladite surface en silicium amorphe hydrogéné dans de l'eau et formation d'une couche chimiquement inactive sur celle-ci par séchage de ladite surface en silicium amorphe hydrogéné sous un rayonnement infrarouge dans une atmosphère contenant de l'oxygène ; et
formation d'une couche d'électrode sur ladite couche chimiquement inactive.

2. Procédé selon la revendication 1, dans lequel ladite couche d'électrode formée sur ladite couche chimiquement inactive est une électrode de collecteur.

3. Procédé selon la revendication 1, dans lequel ladite couche d'électrode formée sur ladite couche chimiquement inactive est une électrode transparente.

4. Procédé selon l'une quelconque des revendications 1 à 3 comprenant :
la formation d'une couche en silicium amorphe hydrogéné soit du type P, soit du type N sur un substrat ; et
la formation d'une couche en silicium amorphe hydrogéné de type I ne comportant pas d'impureté sur ladite couche en silicium amorphe hydrogéné soit de type N, soit de type P ;
et dans lequel la surface dudit silicium amorphe hydrogéné de type I est lavée lors de ladite étape de lavage.

5. Procédé selon l'une quelconque des revendications 1 à 3, comprenant :
la formation d'une couche en silicium amorphe hydrogéné soit de type P, soit de type N sur un substrat ;
la formation d'une couche en silicium amorphe hydrogéné de type I ne comportant pas d'impureté sur ladite couche en silicium amorphe hydrogéné soit de type N, soit de type P ; et
la formation d'une couche en silicium amorphe hydrogéné soit de type P, soit de type N sur ladite couche en silicium amorphe hydrogéné de type I,
et dans lequel la surface du second silicium amorphe hydrogéné soit de type P, soit de type N mentionné est lavée lors de ladite étape de lavage.
